# EUROPEAN PATENT APPLICATION

(11) **EP 4 579 729 A1**
(43) Date of publication of application: **02.07.2025**
(21) Application number: 24221723.0
(22) Date of filing: 19.12.2024
(51) Int. Cl.: H01L 23/15, H01L 23/13, H01L 23/538

(54) **MANUFACTURING METHOD OF PACKAGING SUBSTRATE AND PACKAGING SUBSTRATE USING THE SAME**

(30) Priority: 24.12.2023 US 202363614618 P
(71) Applicant: Absolics Inc., Covington, GA 30014 (US)
(72) Inventor: KIM, Sungjin, Covington, Georgia 30014 (US)
(74) Representative: BCKIP Part mbB

(57) **Abstract**

The present disclosure relates to a packaging substrate, a manufacturing method of packaging substrate, and the like. A packaging substrate according to the present disclosure includes a glass substrate having first and second sides facing each other; a cavity part formed in the glass substrate; and a cavity element disposed in the cavity part. The cavity part includes a cavity space in which at least a portion of the cavity element is inserted, a sidewall surrounding the cavity space, and a gap disposed between a first side of the cavity element and the sidewall, the gap being filled with one or more types of filling material. By doing so, the volume for filling the gap between the sidewall of the cavity part and the cavity element can be reduced, and the utilized area of the glass substrate can be increased, the loss of the filling material can be reduced, and the surface fluctuation can be reduced to produce effects that favor the formation of an additional build-up layer.

## Description

### BACKGROUND

### 1. Field

This document relates to a substrate for packaging, a semiconductor package, a manufacturing method of packaging substrate, a manufacturing method of semiconductor package, and the like.

### 2. Description of Related Art

When building an electronic component, implementing the circuitry on a semiconductor wafer is called the Front-End (FE), and assembling the wafer into a product-ready state is called the Back-End (BE). The latter includes the packaging process.

There are four core technologies in the semiconductor industry that have enabled the rapid development of electronic products in recent years: semiconductor technology, semiconductor packaging technology, manufacturing process technology, and software technology. Semiconductor technology is advancing in various forms, including sub-micron to nano-scale line widths, more than 10 million cells, high-speed operation, and high heat dissipation, but the technology to package them perfectly is relatively weak. Therefore, the electrical performance of semiconductors is often determined by packaging technology and electrical connections rather than the performance of the semiconductor technology itself.

Substrates for packaging can be made of ceramic or resin. Ceramic substrates, such as silicon substrates, have high resistivity or high dielectric constant, making it difficult to mount high-performance, high-frequency semiconductor devices. In the case of resin substrates, it is possible to mount relatively high-performance, high-frequency semiconductor devices. However, there are limitations in reducing the pitch of the wiring.

Recently, silicon or glass may be used as substrates for high-end packaging. By forming through-holes in the silicon or glass substrate and applying conductive materials to the through-holes, the wiring between the device and the motherboard can be shortened and have good electrical characteristics.

In addition, semiconductor packages can generate heat during operation and may further include heat dissipation means to dissipate this heat.

Relevant prior art includes Korean Patent Publication No. 10-2021-0022980 and Korean Patent Publication No. 10-2022-0050121.

### SUMMARY

An object of the embodiments is to provide a method of manufacturing a packaging substrate in which a gap between a sidewall of a cavity part and a cavity element is formed in a small volume in a packaging substrate in which a glass substrate is used, and to provide a packaging substrate using the method.

In addition, the purpose of the embodiment is to provide a method for manufacturing a packaging substrate that is advantageous for layer build-up formation by reducing surface fluctuations, such as by forming a gap in a tapered shape by slanting the sidewalls of a cavity part to reduce loss of a filling material filling the gap, and a packaging substrate using the same.

To achieve the above objectives, a packaging substrate according to one embodiment includes a glass substrate having first and second sides facing each other; a cavity part formed in the glass substrate; and a cavity element disposed in the cavity part.

The cavity part includes a cavity space into which at least a portion of the cavity element is inserted, a sidewall surrounding the cavity space, and a gap disposed between a first side of the cavity element and the sidewall.

The gap may be filled with one or more types of filling material.

The gap may have a length of 50 *µ*m or less.

The sidewall may be inclined, and an angle between the sidewall and the second side may be 65 degrees or more.

If the sidewalls are sloped, the length of the cap is the largest value of the distance between the sidewall and one side of the cavity element, and the length of the gap may be 50 *µ*m or less.

The cavity part may be full-cavity, wherein the cavity space penetrates the glass substrate; or half-cavity, wherein the cavity space is recessed in the first side or the second side of the glass substrate.

The cavity part may include: an opening side located at an opening of the cavity space; and a bottom surface of a recess in the cavity space or a bottom surface opposite the opening side, wherein the area of the opening side is larger than the area of the bottom surface.

The glass substrate may include a first cavity part and a second cavity part.

A first cavity element may be disposed in the first cavity part, and a second cavity element may be disposed in the second cavity part.

In a cross-sectional view, the sum of the gaps disposed on both sides of the first cavity element and the gaps disposed on both sides of the second cavity element may be 200 ,um or less.

The first cavity element and the second cavity element may be disposed in the cavity part.

In a cross-sectional view, the sum of the gaps disposed on both sides of the first cavity element and the gaps disposed on both sides of the second cavity element may be 150 *µ*m or less.

To achieve the above objectives, a method of manufacturing a packaging substrate according to one embodiment includes: preparing a glass substrate having a cavity part and a cavity element; and disposing and filling the cavity element in the cavity part.

The glass substrate has a first side and a second side facing each other.

The cavity part may comprise a cavity space in which at least a portion of the cavity element is inserted, a sidewall surrounding the cavity space, and a gap disposed between a first side of the cavity element and the sidewall, the filling the gap with a filling material to form a filling part.

Wherein the cavity part is a full cavity wherein the cavity space penetrates the glass substrate, and wherein the placement is performed with a support layer attached beneath the second side, the support layer being removable after the peeling operation.

Wherein the sidewalls are inclined, and wherein the amount of filling material required may be reduced by 30% or more compared to wherein the sidewalls are perpendicular to the second side.

### BRIEF DESCRIPTION OF THE DRAWINGS

FIG. 1 is a conceptual diagram illustrating one example of a glass substrate of a packaging substrate, according to an embodiment.
FIGS. 2A and 2B are conceptual diagrams illustrating cross-sections A-A' of a glass substrate, respectively, according to embodiments.
FIG. 3 is a diagram illustrating an exemplary structure of a packaging substrate, according to one embodiment.
FIGS. 4A and 4B are conceptual diagrams illustrating cross-sections of a glass substrate, according to different embodiments.
FIGS. 5A and 5B are conceptual diagrams illustrating cross-sections of a glass substrate, according to different embodiments.
FIGS. 6A and 6B are conceptual diagrams illustrating cross-sections of a glass substrate, according to different embodiments.
FIGS. 7A and 7B are drawings illustrating an exemplary cross-sectional structure of a packaging substrate generated in accordance with an embodiment, respectively.

### DETAILED DESCRIPTION

In order to provide a comprehensive understanding of the methods, apparatus, and/or systems described herein, the following detailed description is provided. However, various modifications, modifications, and equivalents of the methods, devices, and/or systems described herein will become apparent after understanding what this disclosure presents. For example, the sequence of operations described herein is by way of example only and is not intended to be limiting to the operations described herein. With the exception of steps that are not necessarily performed in a particular order, the order of operations may be altered based on an understanding of what is disclosed herein. Further, descriptions of features already known in the art may be omitted for clarity and brevity after understanding the disclosure of this application. However, the omission of such features and their descriptions is not intended to be recognized as general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the disclosures of this application.

The terms "first," "second," "third," and the like may be used herein to describe various members, components, regions, layers, or sections, but are not intended to limit the members, components, regions, layers, or sections to these words.

Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or there may be one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit disclosure. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but not all examples are limited thereto.

For the purposes of this application, "B being located on A" means that B is placed on top of A, either in direct contact with A or with another layer or structure interposed therebetween, and should not be construed to mean that B is in direct contact with A.

Unless otherwise defined, all terms used herein shall have the same meaning as commonly understood by one of ordinary skill in the art to which the present invention belongs. Such terms, as defined in commonly used dictionaries, shall be construed to have a meaning consistent with their meaning in the context of the prior art and the present invention and shall not be construed in an idealized or overly formal sense unless expressly defined herein.

In one or more of the examples above, a description of "A and/or B" means "A, B, or A and B".

In one or more of the above examples, terms such as "first," "second," "A," or "B" are used to distinguish identical terms from each other.

In one or more of the above examples, singular forms are contextually interpreted to include the plural as well as the singular, unless otherwise noted.

### Packaging Substrate

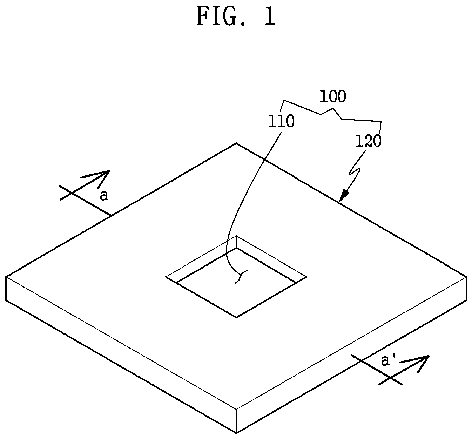

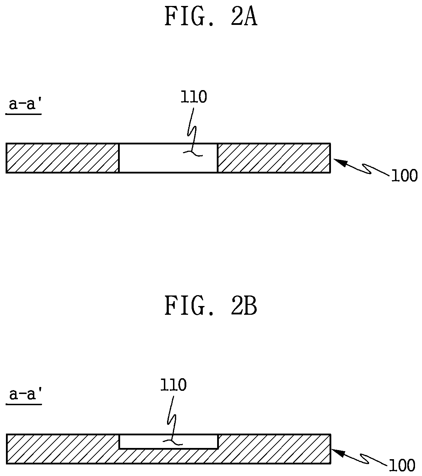

FIG. 1 is a conceptual diagram illustrating an example of a glass substrate of a packaging substrate according to an embodiment, FIG. 2A is a conceptual diagram illustrating an A-A' cross-section of a glass substrate according to an embodiment, and FIG. 2B is a conceptual diagram illustrating an A-A' cross-section of a glass substrate according to another embodiment. Referring now to FIG. 1 to 2B, a glass substrate included in a packaging substrate will be described in detail.

The glass substrate 100, according to one or more examples, comprises a device region 110 and a substrate region 120 that are distinct from each other. The device region 110 is a region in which the cavity part are disposed, and the substrate region 120 is a region in which the cavity part are not disposed. The device region 110 and the substrate region 120 may be disposed adjacent to each other. The glass substrate 100 may comprise one device region 110 or may comprise two or more device regions 110. The device regions may also be referred to as a cavity structure.

The glass substrate 100 has a first side and a second side facing each other, the two sides being substantially parallel to each other and having a constant thickness throughout the glass substrate 100.

As a packaging substrate for semiconductor devices, silicon substrates and organic substrates have traditionally been applied in a laminated form. In the case of silicon substrates, due to the nature of semiconductors, parasitic elements may occur when applied to high-speed circuits, and power losses are relatively high. In addition, organic substrates require large area to form more complex distribution patterns, which is inconsistent with the trend of miniaturization of electronic devices. In order to form a complex distribution pattern within a certain size, pattern refinement is practically necessary, but there were practical limitations in pattern refinement due to the characteristics of materials such as polymers applied to organic plates.

In an embodiment, the glass substrate 100 is applied as a support for the packaging substrate as a way to address these issues. In addition, a core via formed through the glass substrate 100 is applied in conjunction with the glass substrate 100 to provide a packaging substrate having shorter electrical flow lengths, more miniaturized, faster response, and less loss characteristics.

The glass substrate 100 may preferably be a glass substrate applied to a semiconductor, such as, but not limited to, a borosilicate glass substrate, an alkali-free glass substrate, and the like.

The core vias penetrate the glass substrate 100. The core via may be formed by removing a predetermined area of the glass substrate 100, specifically by etching the plate glass by physical and/or chemical means.

Specifically, the formation of the core via may be accomplished by forming defects (recesses) on the surface of the glass substrate by means of a laser or the like, followed by chemical etching, laser etching, and the like, but is not limited to.

The number of core vias may be 100 to 3000 pieces, 100 to 2500 pieces, or 225 to 1024 pieces based on a unit area (1 cm x 1 cm) of the glass substrate 100. If these pitch conditions are satisfied, the formation of an electrically conductive layer or the like and the performance of the packaging substrate can be improved.

The cavity part 110 may comprise a cavity structure.

The cavity structure refers to a structure that comprises a depression in a portion of the glass substrate 100 that allows for placement of an element substantially inside the glass substrate 100. The space formed by the depression is referred to as the cavity space.

The cavity part 110 may comprise a cavity space into which at least a portion of the cavity element is inserted; sidewalls surrounding the cavity space; and a contact surface that is optionally a bottom surface.

Referring to FIGS. 2A and 2B, a cavity part 110 may be created in the glass substrate 100 having first and second sides facing each other.

For example, referring to FIG. 2A, the cavity part 110 may penetrate the first side and the second side of the glass substrate 100 to have a space in which an element is disposed. The cavity space of the cavity part 110 shown in FIG. 2A may be full-cavity through the glass substrate 100.

For example, referring to FIG. 2B, the cavity part 110 may be formed in the form of a recessed surface with only one of the first or second side open. The cavity part 110 may be formed in the form of a recessed surface in which only one of the first or second side is open to provide space for an element to be disposed. The cavity space of the cavity part 110 shown in FIG. 2B may be in the form of a half-cavity in which the first side or the second side of the glass substrate 100 is recessed.

The contact surface of the cavity part 110 is in contact with the element, either directly or through another layer, when the element is disposed in the cavity. The contact surface is disposed opposite the opening.

The sidewall of the cavity part 110 may be a wall surrounding the contact surface, i.e., a wall surrounding the cavity space of the cavity part 110. If the contact surface has a square shape, the sidewall may comprise four sides.

The sidewall connects the contact surface with the first side of the substrate region 120.

The cavity part 110, when viewed through the opening, may be substantially any shape, such as circular, triangular, square, hexagonal, octagonal, cruciform, or otherwise.

On the other hand, a cavity part may be created in the glass substrate as described above, and a cavity element may be disposed in the cavity part. In this case, the cavity part may have a gap disposed between the cavity element and the sidewall in order to prevent the cavity element from an electrical short circuit shorting, etc. A filling part may be disposed in the gap.

The cavity element may comprise an active element, such as a transistor, or a passive element, such as a power transfer element, such as a multilayer ceramic capacitor (MLCC).

If an active element such as a transistor, which plays a role in converting electrical signals between the motherboard and the semiconductor element part to an appropriate level, is applied as the cavity element, it is possible to provide a semiconductor device having a more efficient and faster speed by applying a transistor or the like in the path of the packaging substrate.

In addition, power transfer elements such as multilayer ceramic capacitors (MLCCs) play an important role in the performance of semiconductor devices. Power transfer elements, which are passive elements, may be applied to semiconductor devices at least 200, and depending on the shape, such as a plate type, the number of power transfer elements applied may vary.

Its performance in transferring power is also affected by the properties of the electrically conductive layer surrounding the element. In one embodiment, non-circular shaped core via may be applied where a low resistance electrically conductive layer is required, such as in power transfer elements.

On the other hand, the cavity element may be applied by inserting the elements individually, or a group of elements comprising a plurality of elements in a form embedded between an insulating layer (cavity element insulation layer), wherein the electrodes are formed to be exposed and then inserted into the cavity element. The latter option is more workable for packaging substrate fabrication and more favorable for ensuring that the insulating layer is sufficiently and reliably located in the space between complex elements.

Here, depending on the shape and size of the gap formed, a significant loss of filling material for placing the filling part may occur. Embodiments may substantially reduce the volume of the filling part, which may reduce surface fluctuations of the filling material and may be advantageous for the formation of additional build-up layers.

In other words, the present disclosure proposes embodiments in which the volume of the gap in the cavity part is smaller or the surface fluctuations are reduced, which can increase the utilized area of the glass substrate, reducing the loss of filling material and favoring the formation of additional build-up layers.

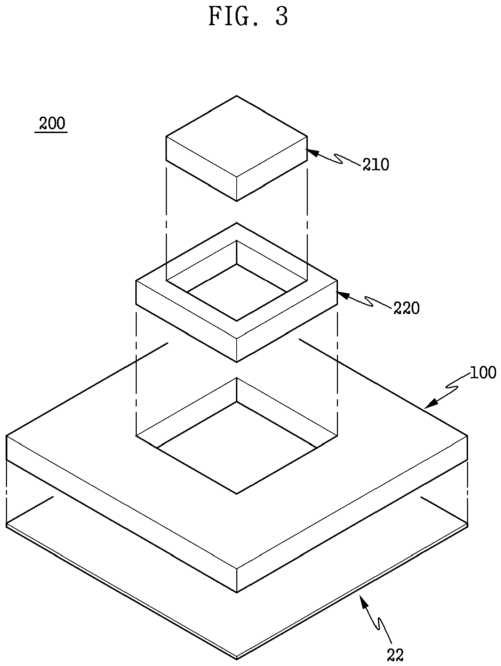

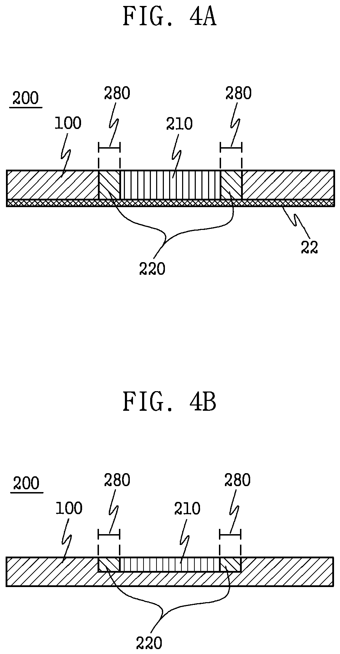

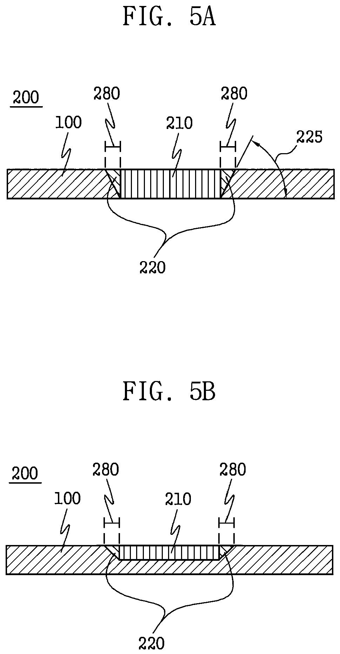

FIG. 3 is a diagram illustrating an exemplary structure of a packaging substrate according to one embodiment, FIG. 4A is a conceptual diagram illustrating a cross-section of a packaging substrate according to an embodiment, and FIG. 4B is a conceptual diagram illustrating a cross-section of a glass substrate according to another embodiment. Further, FIG. 5A is a conceptual diagram illustrating a cross-section of a packaging substrate according to another embodiment, and FIG. 5B is a conceptual diagram illustrating a cross-section of a glass substrate according to another embodiment.

Referring to FIG. 3, the packaging substrate 200 may comprise a glass substrate 100 having a first side and a second side, and a cavity part may be created in the glass substrate 100 having the first side and the second side. A cavity element 210 may be disposed in the cavity part, and a filling part 220 may be disposed in a gap between the cavity element 210 and a sidewall of the cavity part.

Optionally, the packaging substrate 200 may further comprise a film layer 22 positioned beneath the glass substrate 100. The film layer 22 may be applied during manufacturing, utilized for placement of devices and filling in the cavity part, and then removed. The film layer may exemplarily be an adhesive film, such as polyimide tape (PI tape).

In an implementation, after the cavity element 210 is arranged in the cavity part, the filling part 220 may be created. For example, a method of decompression lamination of the filling part 220 in the form of a film may be applied. By performing such pressure-sensitive lamination, the filling part 220 may be sufficiently embedded into the empty space inside the cavity part to form a void-free filling part 220. The filling part 220 may be filled with a filling material.

The filling material may be applied in combination with one or more of the above.

The filling material may be applied in two or more spatially separated areas.

The filling material may be filled separately in two or more. Depending on the time of filling, the filling material may be provided with a boundary line. The demarcation line may be a clear demarcation line made of different materials, or it may be a gradation of the first and second materials partially mixed near the demarcation line.

An insulating material may be applied as the filling material.

The filling material may be a combination of insulating and metallic materials.

The insulating material may be a polymer resin, a mixture of a polymer resin and a filler (inorganic particles, organic particles, organic-inorganic composite particles, etc.)

For example, the polymer resin may be an acrylic resin, an epoxy resin, a modified resin thereof, or the like, and a material applicable to the electronic device for the purpose of molding or the like may be applied. For example, liquid crystal polymer (LCP) and the like may be applied.

Exemplarily, the mixture may be a mixture of an acrylic resin and a filler, a mixture of an acrylic resin and an epoxy resin and a filler, a mixture of an epoxy resin and a filler, and the like. The filler may be an inorganic particle, exemplarily a silica particle.

As commercially available products, Ajinomoto Build-up Film (ABF), Epoxy Molding Compound (EMC), Modified Polyimide (MPI), and the like may be applied, but are not limited to.

The metal material may function as an electrically conductive layer, heat dissipation layer, etc.

The metal material may be copper or an alloy of copper with titanium, chromium, nickel, or the like. Alternatively, the metal material may be aluminum or an alloy comprising aluminum.

If the filling material is filled separately in two or more portions, a demarcation line in the form of a dimple or slope may be provided in the filling part.

Referring to FIG. 4A, the cavity space of the cavity part formed in the glass substrate 100 may be a full-cavity type through the glass substrate 100. The cavity part may comprise a gap 280 disposed between the cavity element 210 and a sidewall of the cavity part, and a filling part 220 may be disposed in the gap 280. For example, the width of the gap 280 may be 50 *µ*m or less, 45 *µ*m or less, 40 *µ*m or less, 35 *µ*m or less, 30 *µ*m or less, or 25 *µ*m or less. The width of the gap 280 may be 15 *µ*m or more, or 20 *µ*m or more. The width of the gap 280 may be different for each of the up and down measurement positions of the gap. The width at the widest position is treated as the width of the cap. Other characteristics, such as the packaging substrate 200 may comprise a film layer 22 positioned below the second side of the glass substrate 100, may apply to any of the above-described embodiments.

Referring to FIG. 4B, the cavity space of the cavity part formed in the glass substrate 100 may be a half-cavity type in which the first side or the second side of the glass substrate 100 is recessed. The cavity part may comprise a cavity space in which at least a portion of the cavity element 210 is inserted, a sidewall surrounding the cavity space, and a contact surface. The cavity part may also comprise a gap 280 disposed between the cavity element 210 and the sidewalls of the cavity part, and a filling part 220 may be disposed in the gap 280. For example, the gap 280 may have a width of 50 *µ*m or less, 45 *µ*m or less, 40 *µ*m or less, 35 *µ*m or less, 30 *µ*m or less, or 25 *µ*m or less. The width of the gap 280 may be 15 *µ*m or more, or 20 *µ*m or more. The width of the gap 280 may be different for each of the up and down measurement positions of the gap. The width at the widest position is treated as the width of the cap. Other characteristics, such as the packaging substrate 200 may comprise a film layer 22 positioned below the second side of the glass substrate 100, may apply to any of the above-described embodiments.

Embodiments are proposed herein in which the gap is formed in a tapered structure such that the volume of the gap in the cavity part is small. For example, the cavity part may comprise a gap disposed between the cavity element and a sidewall, and the sidewall may be inclined at a specific angle relative to a first or second side of the glass substrate. By doing so, the utilized area of the glass substrate can be increased, and the effect of reducing the loading of the filling material and reducing the surface fluctuation of the filling material may be produced to favor the formation of an additional build-up layer.

Referring to FIG. 5A, the cavity space of the cavity part formed in the glass substrate 100 may be a cavity type that penetrates the glass substrate 100. The cavity part may comprise a gap 280 disposed between the cavity element 210 and a sidewall of the cavity part, and a filling part 220 may be disposed in the gap 280. The sidewalls may be inclined at a specific angle 225 relative to a second side of the glass substrate. For example, the specific angle 225 between the sidewall and the second side may be 65 degrees or more, 70 degrees or more, 75 degrees or more, 80 degrees or more, 82 degrees or more, or 83 degrees or more. The specific angle 225 may be 86 degrees or less, or 85 degrees or less.

The cavity part may be characterized by having an opening side located in an opening of the cavity space; and a recessed bottom surface of the cavity space or a bottom surface opposite the opening side, wherein an area of the opening side is larger than an area of the bottom surface.

Other characteristics, such as the width of the gap 280, which may comprise a film layer 22 positioned beneath the second side of the glass substrate 100, and the like, all of the characteristics described above may apply to embodiments.

Referring to FIG. 5B, the cavity space of the cavity part formed in the glass substrate 100 may be a half-cavity type in which the first side or the second side of the glass substrate 100 is recessed. The cavity part may comprise a cavity space in which at least a portion of the cavity element 210 is inserted, a sidewall surrounding the cavity space, and a contact surface. The cavity part may comprise a gap 280 disposed between the cavity element 210 and the sidewalls of the cavity part, and a filling part 220 may be disposed in the gap 280. The sidewalls may be inclined at a specific angle relative to a second side of the glass substrate. For example, the specific angle 225 between the sidewall and the second side may be 65 degrees or more, 70 degrees or more, 75 degrees or more, 80 degrees or more, 82 degrees or more, or 83 degrees or more. The specific angle 225 may be 86 degrees or less, or 85 degrees or less. Other characteristics, such as the width of the gap 280, can be any of the characteristics described above in any embodiment.

A plurality of cavity elements may be disposed on a glass substrate. The present disclosure proposes an embodiment in which a gap is formed in a cavity part in which the plurality of cavity elements are disposed.

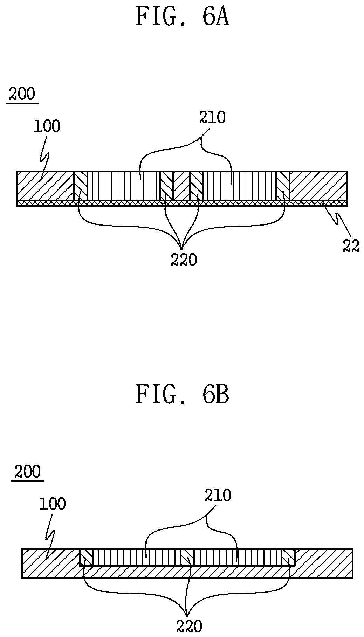

FIG. 6A is a conceptual diagram illustrating a cross-sectional view of a packaging substrate, according to another embodiment, and FIG. 6B is a conceptual diagram illustrating a cross-sectional view of a glass substrate, according to another embodiment.

Referring to FIG. 6A, the cavity space of the cavity part formed in the glass substrate 100 may be a cavity type that penetrates the glass substrate 100. A plurality of cavity elements 210 may be disposed in the cavity part.

For example, the glass substrate 100 may comprise a first cavity part and a second cavity part, wherein a first cavity element is disposed in the first cavity part and a second cavity element is disposed in the second cavity part. The first cavity part may comprise a gap 280 disposed between the first cavity element and a sidewall of the first cavity part, and the second cavity part may comprise a gap 280 disposed between the second cavity element and a sidewall of the second cavity part. Further, a gap 280 may be disposed between the first cavity part and the second cavity part. Referring to FIG. 6A, in a cross-sectional view, gaps may be disposed on both sides of the first cavity element and on both sides of the second cavity element. For example, in a cross-sectional view, the sum of the gaps disposed on both sides of the first cavity element and the gaps disposed on both sides of the second cavity element may be 200 *µ*m or less. The sum of the gaps may be 200 *µ*m or less, 190 *µ*m or less, 180 *µ*m or less, 170 *µ*m or less, 160 *µ*m or less, 150 *µ*m or less, 140 *µ*m or less, 130 *µ*m or less, 120 *µ*m or less, 110 *µ*m or less, 100 *µ*m or less, or 98 *µ*m or less. The sum of the gaps may be 60 *µ*m or more, 70 *µ*m or more, or 80 *µ*m or more. A filling part 220 may be disposed in the gap 280.

Other characteristics, such as the specific angle 225 between the sidewall and the second side, and the film layer 22 that may be positioned below the second side of the glass substrate 100, may be included in any of the embodiments described above.

Alternatively, for example, but not shown in FIG. 6A, a first cavity element and a second cavity element may be disposed together in a single cavity part. In cross-sectional view, the cavity part may comprise a gap between the first cavity element and the second cavity element, and two gaps disposed between the cavity element and the sidewall, respectively. In this case, the sum of the gaps may be 150 *µ*m or less, 140 *µ*m or less, 130 *µ*m or less, 120 *µ*m or less, 100 *µ*m or less, 90 *µ*m or less, or 80 *µ*m or less. The sum of the gaps may be 50 *µ*m or more, 60 *µ*m or more, or 70 *µ*m or more. A filling part 220 may be disposed in the gap 280.

Other characteristics, such as the specific angle 225 between the sidewall and the second side, and the film layer 22 that may be positioned below the second side of the glass substrate 100, may be included in any of the embodiments described above.

Referring to FIG. 6B, the cavity space of the cavity part formed in the glass substrate 100 may be a half-cavity type in which the first side or the second side of the glass substrate 100 is recessed. The cavity part may comprise a cavity space in which at least a portion of the cavity element 210 is inserted, a sidewall surrounding the cavity space, and a contact surface.

For example, the glass substrate 100 may comprise a cavity part, wherein a first cavity element and a second cavity element may be disposed. The cavity part may comprise a gap 280 disposed between the first cavity element and a sidewall of the cavity part and a gap 280 disposed between the second cavity element and a sidewall of the cavity part. Further, a gap 280 may be disposed between the first cavity element and the second cavity element. Referring to FIG. 6A, in a cross-sectional view, gaps may be disposed on both sides of the first cavity element and on both sides of the second cavity element. For example, in the cross-sectional view, the sum of the gaps disposed on both sides of the first cavity element and the gaps disposed on both sides of the second cavity element may be 150 ,um or less, i.e., the sum of the gaps may be 150 ,um or less, 140 *µ*m or less, 130 *µ*m or less, 120 *µ*m or less, 100 *µ*m or less, 90 *µ*m or less, or 80 *µ*m or less. The sum of the gaps may be 50 *µ*m or more, 60 *µ*m or more, or 70 *µ*m or more. A filling part 220 may be disposed in the gap 280. The filling part 220 may be disposed in the gap 280.

Although not shown in FIG. 6B, the glass substrate 100 may comprise a first cavity part and a second cavity part, wherein a first cavity element is disposed in the first cavity part and a second cavity element is disposed in the second cavity part. The first cavity part may comprise a gap 280 disposed between the first cavity element and both sidewalls of the first cavity part, and the second cavity part may comprise a gap 280 disposed between the second cavity element and both sidewalls of the second cavity part. The sum of the gaps may be 200 *µ*m or less, 190 *µ*m or less, 180 *µ*m or less, 170 *µ*m or less, 160 *µ*m or less, 150 *µ*m or less, 140 *µ*m or less, 130 *µ*m or less, 120 *µ*m or less, 110 *µ*m or less, 100 *µ*m or less, or 98 *µ*m or less. The sum of the gaps may be 60 *µ*m or more, 70 *µ*m or more, or 80 *µ*m or more. A filling part 220 may be disposed in the gap 280.

Other characteristics, such as the specific angle 225 between the sidewall and the second side, and the film layer 22 that may be positioned below the second side of the glass substrate 100, may be included in any of the embodiments described above.

Further, the packaging substrate 200 according to one embodiment comprises a glass substrate 100, an upper layer 300 located on a surface of the glass substrate 100, and a cavity part 110 in which a cavity element may be located.

The packaging substrate 200 may further comprise a lower layer 400 positioned below the other side of the glass substrate 100.

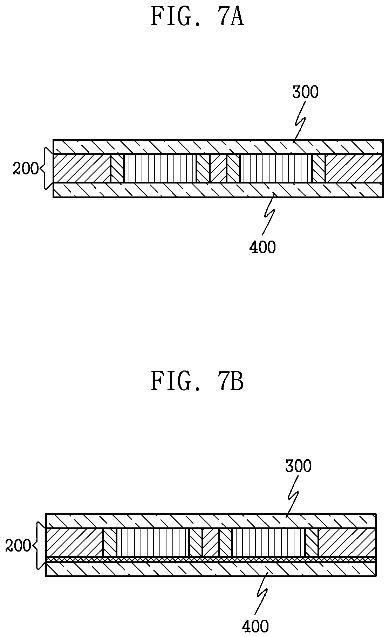

FIGS. 7A through 7B are examples of cross-sectional structures of a packaging substrate generated in accordance with embodiments.

Referring to FIG. 7A, the packaging substrate 200 may comprise a glass substrate having a cavity part comprising a cavity element and a gap, wherein an upper layer 300 may be disposed on one side of the glass substrate 100, and a lower layer 400 may be disposed on the other side of the glass substrate 100. Also, referring to FIG. 7B, the packaging substrate 200 may comprise a glass substrate and a film layer in which a cavity part comprising a cavity element and a gap is formed, and the upper layer 300 may be disposed on a first side of the glass substrate 100, and the lower layer 400 may be disposed on the other side of the glass substrate 100.

The upper layer 300 may comprise an upper distribution layer and a top surface contact layer positioned on the upper distribution layer, and the uppermost surface of the upper layer 300 may be protected by a cover layer having an opening through which the contact electrodes of the semiconductor element can directly contact.

The upper distribution layer comprises an upper insulating layer positioned on the first surface; an electrically conductive layer having a predetermined pattern and electrically connected to at least a portion of the core distribution layer, and an upper distribution pattern embedded in the upper insulating layer.

The upper insulating layer may be applied as an insulating layer to a semiconductor device or packaging substrate, and may be applied, for example, as an epoxy-based resin containing a filler, but is not limited to.

The insulating layer may be formed by forming a coating layer and curing it, or it may be formed by laminating an uncured or semi-cured insulating film to the glass substrate 100 and curing it. In this case, by applying a pressure-sensitive lamination method or the like, the insulating is embedded into the space inside the core vias, and an efficient process is possible.

### Semiconductor Devices

To accomplish the above objectives, a semiconductor device according to an embodiment comprises a semiconductor element portion in which one or more semiconductor elements are located; a packaging substrate electrically connected to the semiconductor element; and a motherboard electrically connected to the packaging substrate and transmitting external electrical signals to and from the semiconductor element.

The semiconductor element part refers to an element mounted on a semiconductor element and is mounted on the packaging substrate by means of a connection electrode or the like. Specifically, the semiconductor element part may comprise, for example, a computing element such as a CPU or GPU, a memory element such as a memory chip, or the like, but any semiconductor element mounted on a semiconductor element may be applied without limitation.

The motherboard may be a printed circuit board, a printed wiring board, or the like.

In some embodiments, the plurality of insulating layers may be stacked and substantially indistinguishable from one another, and the plurality of insulating layers are collectively referred to as the upper insulating layer. Further, the core insulation layer and the upper insulating layer may contain the same insulating material, in which case the boundary between them may be substantially indistinguishable. Alternatively, in other implementations, the boundaries of the insulating layers may be created by setting different pressures and temperatures to cure the multiple insulating layers.

The upper distribution pattern refers to an electrically conductive layer located within the upper insulating layer in a predetermined shape, which may be formed, for example, by a build-up layer method. Specifically, an electrically conductive layer may be formed by forming an insulating layer, removing an unnecessary portion of the insulating layer, forming an electrically conductive layer by copper plating or the like, optionally removing an unnecessary portion of the electrically conductive layer, forming an insulating layer on top of the electrically conductive layer, removing an unnecessary portion of the insulating layer, forming an electrically conductive layer by plating or the like, and repeating the process to form an upper distribution pattern in which the electrically conductive layer is formed in a vertical or horizontal direction in the desired pattern.

Since the upper distribution pattern is located between the glass substrate 100 and the semiconductor element part, it is formed to comprise a fine pattern in at least a portion thereof so that the transmission of electrical signals to the semiconductor element part may proceed smoothly and the intended complex pattern may be sufficiently accommodated. In this case, the fine patterns may have a width and spacing of less than 4 *µ*m, 3.5 *µ*m or less, 3 *µ*m or less, 2.5 *µ*m or less, 2.3 *µ*m, or the like. The width and spacing may be 1 *µ*m or more (hereinafter, the description of the fine patterns will be the same).

The top surface contact layer comprises a top surface connection pattern located in the upper insulating layer and electrically connected to at least a portion of the upper distribution pattern, and a top surface contact electrode electrically connecting the semiconductor element portion and the upper surface connection pattern. The top surface connection pattern may be located on a first surface of the upper insulating layer, or at least a portion thereof may be exposed and embedded in the upper insulating layer. For example, in the case where the top surface connection pattern is located on one side of the upper insulating layer, the upper insulating layer may be formed by plating or the like, and in the case where the top surface connection pattern is embedded with a portion of the top surface connection pattern exposed on the upper insulating layer, the portion of the insulating layer or the electrically conductive layer may be removed by surface polishing, surface etching, or the like after forming a copper plating layer or the like.

The top surface connection pattern may comprise at least a portion of a fine pattern, such as the upper distribution pattern described above. A top surface connection pattern comprising such fine-patterns enables a larger number of elements to be electrically connected in a smaller area, facilitating better electrical signal connections between elements or to the outside world, and enabling more integrated packaging.

The top surface contact electrode may be directly connected to the semiconductor element and the terminal or the like, or it may be connected via an organic connection such as a solder ball.

The packaging substrate 200 is also connected with a motherboard. The motherboard may be electrically connected to the core distribution pattern located on at least a portion of the second side of the glass substrate 100 by terminals on the motherboard, which may be directly connected, or may be electrically connected via board connections such as solder balls. In addition, the core distribution pattern abutting the motherboard may be connected to the motherboard via a lower layer 400 located on a lower portion of the glass substrate 100.

In one example, the packaging substrate 200 positioned between the semiconductor component and the motherboard may not have substantially any additional substrate other than the glass substrate.

### Manufacturing Method of Packaging Substrate

To achieve the above objectives, the present disclosure proposes a method for manufacturing a substrate for packaging according to embodiments. For example, a method of manufacturing a substrate for packaging according to an embodiment of the present disclosure comprises operations of: preparing a glass substrate having a cavity part and a cavity element; and disposing of the cavity element and filling in the cavity part.

A glass substrate having a cavity part created in a plate glass having first and second sides facing each other may be applied as the glass substrate. A glass substrate having through vias further formed along with the cavity part may be applied. The specific description of the shape, characteristics, etc. of the cavity part is redundant to the above description, so detailed description is omitted.

The cavity part of the glass substrate may be formed by a defect forming process and an etching process. A glass substrate having a cavity part and/or through vias may be obtained by forming a defect with a laser or the like at a location where the cavity and/or through vias are to be formed, immersing the glass substrate in an etching solution, and utilizing the difference in etching speed to obtain a glass substrate having a cavity part and/or through vias.

Next, cavity elements may be disposed in the cavity part. The cavity elements may comprise active elements, such as transistors, or passive elements, such as power transfer elements, such as multilayer ceramic capacitors (MLCCs).

When the cavity element is disposed in the cavity part, a gap is formed between the cavity element and the sidewall of the cavity part as described above, and a detailed description thereof will be omitted as it is redundant with the above description.

If the cavity part is full-cavity, a support layer, such as a film layer, may be placed under the second side of the glass substrate prior to placing the cavity elements, and the film layer may be an adhesive film. In this case, it may be more advantageous to align the position of the cavity elements in the full-cavity cavity part.

The filling material to be filled in the gap may be any filling material described above. The filling material may be, for example, a material that is curable by means of ultraviolet curing, thermal curing, or the like, and thus the formation of the filling part may comprise placing the filling material in the gap by means of pressure sensitive lamination or the like, and curing the filling material by means of ultraviolet curing, thermal curing, or the like.

The formation of the filling part may be carried out in one or more filling processes.

For example, a filling material (primary filling material) is used to form a first filling part through primary vacuum lamination before curing, followed by curing or semi-curing. Subsequently, a filling material (secondary filling material) is used to form a second filling part through secondary vacuum lamination before curing, which is also followed by curing or semi-curing. In this case, when viewed in cross-section, there may be a boundary line between the first and second filling parts. Additionally, when the formation of the filling part is divided into first and second stages, the boundary between these parts may be observable. Moreover, forming the filling parts in two or more stages may reduce stress on the glass substrate, which may help suppress warpage. Furthermore, multiple fillings may effectively inhibit the formation of dimples and slopes on the surface of the filling part.

On the other hand, an upper layer may be disposed on one side of the packaging substrate, and a lower layer may be disposed on the other side of the packaging substrate. The formation of the upper layer and/or the formation of the lower layer may be applicable in a manner of forming a redistribution line.

For example, an upper layer manufacturing operation might look like this.

The operation of manufacturing the upper layer is to form an upper distribution layer comprising an upper insulating layer and an upper distribution pattern on the core layer. The upper insulating layer may be formed by coating a resin composition forming an insulating layer or by laminating an insulating film, preferably by laminating an insulating film. The lamination of the insulating film may be carried out by laminating the insulating film and curing it, in which case a pressure-sensitive lamination method may be applied so that the insulating resin may be sufficiently impregnated even in a layer that does not have an electrically conductive layer formed inside the core via. The upper insulating layer is also applied in direct contact with the glass substrate at least in part, and thus has sufficient adhesion. In particular, the glass substrate and the upper insulating layer are preferably characterized by an adhesion test value of 4B or higher according to ASTM D3359.

The upper distribution pattern may be formed by repeating the process of forming the insulating layer, forming the electrically conductive layer in a predetermined pattern, and etching the unnecessary parts to form the etching layer of the electrically conductive layer, or, in the case of electrically conductive layers that are neighboring with the insulating layer, forming a blind vias on the insulating layer and proceeding with the plating process. Dry etching methods such as laser etching and plasma etching, and wet etching methods using masking layers and etching solutions can be applied to form blind vias.

Then, although not shown, a top surface contact layer and a cover layer may be formed.

The top surface connection pattern and the top surface contact electrode may also be formed by a process similar to the formation of the upper distribution layer. Specifically, it may be formed by forming an etching layer of an insulating layer on an insulating layer, forming an electrically conductive layer on the insulating layer, forming an etching layer of an electrically conductive layer, and so on, but it may also be applied by selectively forming only the electrically conductive layer without applying the method of etching. The cover layer may be formed in such a way that an opening is formed at a position corresponding to the top surface contact electrode so that the top surface contact electrode may be exposed and directly connected to an electrical connection or a terminal of the element.

Once the upper layer has been created, the lower layer may be processed by forming the bottom surface contact layer and cover layer. The bottom distribution layer and/or the bottom surface contact layer, and optionally the cover layer, may be formed in a similar manner to the operations for forming the top surface contact layer and cover layer described above.

The manufacturing method of the packaging substrate according to the above-described embodiments and the packaging substrate using the same may have the effect of reducing the volume of the gap between the sidewall of the cavity part and the cavity element, thereby increasing the utilized area of the glass substrate, reducing the loss of the filling material, and reducing the surface fluctuation of the filling material, thereby favoring the formation of an additional build-up layer.

The manufacturing method of the packaging substrate, packaging substrate, etc. of the embodiment can reduce the volume for filling the gap between the sidewall of the cavity part and the cavity element, thereby increasing the utilized area of the glass substrate, reducing the loss of the filling material, and reducing the surface fluctuation to favor the formation of an additional build-up layer.

In addition, the volume for filling the gap between the sidewall of the cavity part and the cavity element can be reduced by forming the sidewall of the cavity part in an inclined manner, etc., thereby increasing the utilized area of the glass substrate, reducing the loss of the filling material, and reducing the surface fluctuation, thereby creating an effect that favors the formation of an additional build-up layer.

The above-described disclosure has been described with reference to the embodiments shown in the drawings, but these are exemplary only, and those having ordinary knowledge in the art will understand that various modifications and variations of the embodiments are possible from them. In other words, the scope of the disclosure is not limited to the embodiments described above, but also to various modifications and improvements of the embodiments and embodiments of those skilled in the art utilizing the basic concepts of the embodiments defined in the following claims. Accordingly, the true technical scope of the disclosure is to be determined by the technical ideas of the appended claims.

## Claims

1. A packaging substrate, comprising
a glass substrate with first and second sides facing each other;
a cavity part formed in the glass substrate; and
a cavity element disposed in the cavity part,
wherein the cavity part comprises
a cavity space into which at least a portion of the cavity element is inserted;
sidewalls enclosing the cavity space; and
a gap disposed between a first side of the cavity element and the sidewall;
wherein the gap is filled with one or more types of filling material and
wherein the gap has a length of 50 *µ*m or less.

2. The packaging substrate of claim 1,
wherein the sidewalls are sloped,
the angle between the sidewall and the second side is greater than or equal to 65 degrees, and the length of the cap is the largest of the distances between the sidewall and one side of the cavity element.

3. The packaging substrate of claim 1 or claim 2,
wherein the cavity part is full-cavity type wherein the cavity space penetrates the glass substrate,
wherein the cavity part has an opening side located in the opening of the cavity space; and a bottom surface opposite the opening side, and
wherein the area of the opening side is larger than the area of the bottom surface.

4. The packaging substrate of any one from claim 1 to claim 3,
wherein the cavity part is half-cavity type wherein the first side or the second side of the glass substrate is recessed,
wherein the cavity part has an opening side located in the opening of the cavity space a recessed bottom surface of the cavity space, and
wherein the area of the opening side is larger than the area of the bottom surface.

5. The packaging substrate of any one from claim 1 to claim 4,
wherein the glass substrate comprises a first cavity part and a second cavity part,
wherein a first cavity element is disposed in the first cavity part, and a second cavity element is disposed in the second cavity part, and
wherein in a cross-sectional view, the sum of the gaps disposed on both sides of the first cavity element and the gaps disposed on both sides of the second cavity element is 200 *µ*m or less.

6. The packaging substrate of any one from claim 1 to claim 5,
wherein a first cavity element and a second cavity element are disposed in the cavity part, and when viewed in cross-section, the sum of the gaps disposed on both sides of the first cavity element and the gaps disposed on both sides of the second cavity element is 150 *µ*m or less.

7. A method of manufacturing a substrate for packaging, comprising operations of,
preparing a glass substrate having a cavity part and a cavity element; and
disposing a cavity element in the cavity part and filling the cavity part ;
wherein the glass substrate has first and second sides facing each other,
wherein the cavity part comprises
a cavity space into which at least a portion of the cavity element is inserted;
sidewalls enclosing the cavity space; and
a gap disposed between a first side of the cavity element and the sidewall;
wherein the filling comprises filling the gaps with a filling material to form a filling part, and wherein the gap has a length of 50 ,um or less.

8. A method of claim 7,
wherein the cavity part is a full cavity wherein the cavity space penetrates the glass substrate, the arrangement is carried out with the support layer attached under the second side, and wherein the support layer is removed after the operation of peeling.

9. A method of claim 7 or claim 8,
wherein the sidewalls are sloped, and compared to the sidewall being perpendicular to the second side, the requirement of the filling material is reduced by at least 30%.
